# DEMANDE DE BREVET EUROPEEN

(11) **EP 2 996 142 A1**
(43) Date de publication de la demande: **16.03.2016**
(21) Numéro de dépôt: 15184479.2
(22) Date de dépôt: 09.09.2015
(51) Int. Cl.: H01L 23/00, F21S 8/10, F21K 99/00, H01L 23/482, H01L 23/14, H01L 21/02, H05K 1/03, H05K 1/02, F21V 19/00, H05K 1/11, F21Y 101/00, F21Y 105/00

(54) **SUPPORT DE SOURCE LUMINEUSE AVEC CONNECTEUR INTEGRE**

(30) Priorité: 15.09.2014 FR 1458669
(71) Demandeur: VALEO VISION, 93012 Bobigny Cedex (FR)
(72) Inventeur: JIN, Hui, 75014 PARIS (FR); DUBOSC, Christophe, 93250 VILLEMOMBLE (FR); BRIAND, Maxime, 72560 CHANGE (FR); HUE, David, 95430 BUTRY SUR OISE (FR); ZOJCESKI, Zdravko, 92400 COURBEVOIE (FR)

(57) **Abrégé**

L'invention a trait à un support de source(s) lumineuse(s) pour module lumineux, notamment pour véhicule automobile, comprenant un substrat (4) avec au moins une zone de réception d'une source lumineuse (16), et des pistes électriques (18) déposées sur le substrat (4) jusqu'à la ou les zones de réception de source(s) lumineuse(s), lesdites pistes étant destinées à alimenter la ou les sources lumineuses (16). Le substrat (4) comprend au moins une portion en saillie (20) venue de matière avec le reste du substrat et sur laquelle les pistes électriques (18) s'étendent depuis la ou les zones de réception, ladite ou lesdites portions (20) étant aptes à coopérer avec un connecteur électrique (14), respectivement.

## Description

L'invention a trait au domaine de l'éclairage et/ou de la signalisation lumineuse, notamment pour véhicule automobile. Plus précisément, l'invention a trait au domaine de l'éclairage et de la signalisation lumineuse au moyen de diodes à électroluminescence (LED) et de diodes à électroluminescence organiques (OLED).

Le document de brevet US 2005/0243558 A1 divulgue un support de diodes LED pour un module de signalisation du type feux arrière de véhicule automobile. Il est constitué d'une platine avec circuit imprimé et comprenant une série d'orifices au travers desquels sont insérées des diodes LED du type à montage inversé. Ces LED comprennent des parties optiques en forme de dômes, ces dômes étant visibles du côté de la face avant. Les LED comprennent des pattes de fixation et de connexion électrique soudées avec des pistes électriques sur la face arrière de la platine. Ce montage fournit un support esthétique lorsqu'il est observé depuis un point de vue situé du côté de la face avant, les connexions électriques étant exclusivement sur la face arrière. De plus, il permet la mise en place d'un radiateur sur la face arrière de la base de la LED. Les pistes électriques s'étendent jusqu'à un bord de la platine en vue de pouvoir assurer une connexion avec une alimentation. Les pistes électriques se terminent par des zones circulaires typiques de liaison par soudure. Or les opérations de soudure requièrent un soin particulier et constituent une étape supplémentaire lors de l'assemblage du support.

Le document de brevet publié FR 2 995 657 A1 divulgue une source de lumière à diodes du type OLED, comprenant un support avec des cavités remplies par les diodes. Le support comprend sur une de ses faces des électrodes ou pistes électriques destinées à contacter électriquement les diodes en vue de leur alimentation électrique. Les diodes comprennent un empilement de couches organiques et un substrat transparent disposé sur l'empilement en question. Le substrat présente une surface de taille supérieure à celle des couches organiques afin de s'étendre au-delà de la cavité correspondante et ainsi à venir contacter les pistes électriques, aux abords de la cavité. Le support est réalisé par injection de matière isolante telle que du plastique thermoplastique ou thermodurcissable. Il peut être plan, avec un ressaut ou encore de forme plus complexe. Les pistes électriques se limitent à assurer l'alimentation des diodes. Cet enseignement n'aborde pas la problématique de la connexion à une alimentation électrique.

L'invention a pour objectif de proposer un support de source(s) lumineuse(s) pour module lumineux dont la connexion électrique est simplifiée.

L'invention a pour objet un support de source(s) lumineuse(s) pour module lumineux, notamment pour véhicule automobile, comprenant : un substrat avec au moins une zone de réception d'une source lumineuse ; des pistes électriques déposées sur le substrat jusqu'à la ou les zones de réception de source(s) lumineuse(s), lesdites pistes étant destinées à alimenter la ou les sources lumineuses ; remarquable en ce que le substrat comprend au moins une portion en saillie venue de matière avec le reste du substrat et sur laquelle les pistes électriques s'étendent depuis la ou les zones de réception, ladite ou lesdites portions étant des portions de connexion aptes à coopérer avec un connecteur électrique, respectivement.

Certaines des pistes électriques peuvent s'étendre au moins sur une partie d'une surface avant du support. Ladite surface avant est une surface du support qui, lorsque le support est monté sur un véhicule, est visible depuis l'extérieur du véhicule.

Les pistes forment avantageusement un réseau de pistes, ces pistes pouvant être de même largeur.

Par « venue de matière » on entend que la ou les portions de connexion sont réalisées dans la même matière que le reste du substrat et que leur liaison avec le reste du substrat est réalisée lors de leur mise à forme commune, notamment par moulage.

Selon un mode avantageux de l'invention, le substrat est une pièce moulée rigide présentant une forme en trois dimensions. Avantageusement, le substrat est constitué essentiellement d'une paroi d'une épaisseur moyenne comprise entre 0.5 et 3mm.

Selon un mode avantageux de l'invention, le substrat est dans un matériau thermoplastique dopé en particules métalliques de manière à permettre l'accrochage des pistes électriques en matériau métallique.

Avantageusement, le substrat peut être réalisé en un matériau thermoplastique, les pistes électriques étant imprimées sur le substrat lui-même. L'impression peut être du type jet d'encre dont l'encre comprend des particules métalliques. En variante, les pistes peuvent être réalisées par impression ou sérigraphie sur un film en polytéréphtalate d'éthylène (PET) ou en polyéthylène naphthalate (PEN), le film étant déposé sur le substrat, par exemple par thermo-déformation. Encore en variante, les pistes peuvent également être réalisées par un moulage en deux étapes du substrat, ou encore désigné « Two shot molding » en langue anglaise. Il s'agit d'un processus de moulage par injection en utilisant deux résines différentes où une seule des deux résines est métallisable. Le substrat est ensuite soumis à un processus de dépôt auto-catalytique où du butadiène est utilisé pour chimiquement rendre la surface rugueuse et permettre l'adhérence d'une couche primaire de cuivre.

Selon un mode avantageux de l'invention, la ou au moins une des portions de connexion a une forme de languette avec deux faces principales opposées, les pistes électriques s'étendant préférentiellement sur lesdites deux faces.

Selon un mode avantageux de l'invention, la ou au moins une des portions de connexion en forme de languette présente sur une zone distale destinée à pénétrer dans le connecteur une épaisseur réduite par rapport à l'épaisseur d'une zone proximale de ladite portion, l'épaisseur de la zone distale étant préférentiellement inférieure à 50% de l'épaisseur de la zone proximale. Les zones distale et proximale s'entendent par rapport au substrat. Plus précisément, par zone proximale on entend une zone de la portion de connexion qui est plus proche du support qu'une zone distale de ladite portion, la zone distale étant alors plus éloignée du support. Avantageusement, la transition entre les deux zones distale et proximale forme un ressaut. Le ressaut est présent sur les deux faces principales de la portion de connexion.

Avantageusement, les pistes électriques s'étendent essentiellement parallèlement les unes aux autres et selon l'axe principal de la portion de connexion. En l'occurrence l'axe principal de la portion de connexion correspond à l'axe optique et longitudinal du module. Les pistes électriques peuvent s'étendre essentiellement jusqu'au bord distal de la portion de connexion, de manière à s'étendre sur la totalité de la zone distale.

Selon un mode avantageux de l'invention, la ou au moins une des portions de connexion comprend une encoche servant de détrompeur avec le connecteur correspondant. L'encoche peut être prévue sur un seul des deux côtés de la portion de connexion, ladite encoche autorisant à un bord correspondant du connecteur d'avancer jusqu'à ce que le connecteur soit en position d'engagement sur la portion de connexion.

Selon un mode avantageux de l'invention, le support comprend la ou les sources lumineuses, ladite ou lesdites sources étant du type diode à électroluminescence et reliées aux pistes électriques par une colle chargée de particules métalliques, ladite colle étant préférentiellement une colle polymère apte à polymériser après application. En variante, la ou les sources lumineuses peuvent être reliées aux pistes électriques par une soudure à base d'étain, de cuivre ou d'autres métaux.

Selon un mode avantageux de l'invention, le substrat comprend une portion centrale et une cavité avec un fond et au moins une paroi latérale, la ou au moins une des zones de réception de source(s) lumineuse(s) étant sur le fond de la cavité, la ou les portions de connexion étant en saillie depuis la portion centrale dans une direction opposée à la cavité. Si on le souhaite, la ou au moins une des zones de réception peut également être disposée sur une face arrière de la paroi latérale.

Avantageusement, les sources lumineuses, préférentiellement du type LED, sont disposées directement sur le substrat et sont alimentées électriquement par les pistes électriques s'étendant de manière continue depuis lesdites sources jusqu'à la portion de connexion.

Selon un mode avantageux de l'invention, le substrat comprend au moins une paroi frontale faisant saillie de la ou d'au moins une des parois latérales, au moins une des pistes électriques s'étendant sur ladite ou au moins une desdites parois frontales et étant destinée à être reliée à la masse en vue de former un blindage électromagnétique.

Selon un mode avantageux de l'invention, le support comprend, en outre : une pièce rapportée sur le substrat, ladite pièce comprenant une ouverture destinée à recevoir la ou au moins une des portions de connexion du substrat.

Selon un mode avantageux de l'invention, la pièce rapportée comprend au moins une portion en saillie supportant une source lumineuse du type diode à électroluminescence organique.

L'invention a également pour objet un module lumineux, notamment pour véhicule automobile, comprenant : un support de source(s) lumineuse(s) ; au moins un dispositif optique apte à dévier des rayons lumineux produit par la ou les sources lumineuses en vue de former au moins un faisceau lumineux ; remarquable en ce que le support est conforme à l'invention.

Selon un mode avantageux de l'invention, le ou les dispositifs optiques sont supportés directement par le substrat.

Selon un mode avantageux de l'invention, le ou au moins un des dispositifs optiques comprend un élément translucide ou transparent formant au moins un, préférentiellement deux dioptres, ledit élément étant un collimateur de rayons optiques en vue de former le ou un des faisceaux lumineux.

Selon un mode avantageux de l'invention, le ou un des collimateurs est logé dans la cavité du support.

Les mesures de l'invention sont intéressantes en ce qu'elles permettent de réaliser un support avec un niveau d'intégration élevé. En effet, le support comprend au moins une portion de connexion d'un seul tenant avec le reste du substrat. Les pistes électriques peuvent alors être déposées directement sur le substrat, depuis les sources lumineuses jusqu'à la dite ou auxdites portions ou vice versa. Le substrat peut ainsi être moulé selon une forme complexe et servir non seulement de support de sources lumineuses mais également de support pour des pièces optiques et être par ailleurs un élément visible, et donc esthétique, d'un module lumineux.

D'autres caractéristiques et avantages de la présente invention seront mieux compris à l'aide de la description et des dessins parmi lesquels :
- La figure 1 est une vue en perspective d'un module lumineux conforme à l'invention ;
- La figure 2 est une autre vue en perspective du module lumineux de la figure 1;
- La figure 3 est une vue éclatée du support de sources lumineuses du module des figures 1 et 2 ;
- La figure 4 est une vue de face arrière du substrat du support de la figure 3 ;
- La figure 5 est une vue en perspective du substrat des figures 3 et 4, ainsi que de son connecteur ;
- La figure 6 est une vue en perspective du connecteur de la figure 5.

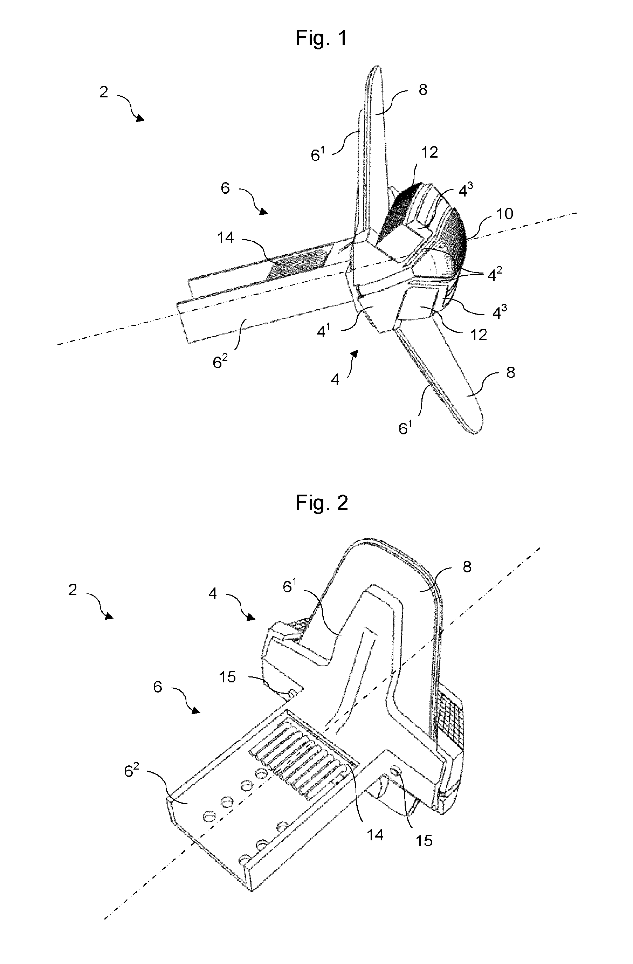

Les figures 1 et 2 illustrent un module de signalisation lumineuse pour véhicule automobile. Le module 2 est configuré pour être logé dans un boîtier disposé à l'arrière du véhicule. Il est configuré pour assurer une fonction de lanterne (ou feux arrière), une fonction de feux stop et une fonction d'indicateur de direction (ou clignotant).

Le module 2 comprend un substrat 4 et une pièce 6 rapportée sur le substrat. La pièce rapportée 6 peut être fixée au substrat au moyen des vis 15. Le substrat 4 comprend, essentiellement, une partie centrale 4¹, deux parois latérales 4², deux parois frontales 4³ faisant saillie des parois latérales 4². Les deux parois latérales 4² forment une cavité logeant des sources lumineuses (non visibles aux figures 1 et 2) ainsi qu'un collimateur 10 en vue de former un faisceau lumineux pour une fonction d'indicateur de direction.

La pièce rapportée 6 comprend deux supports 6¹ et une partie arrière 6². Les supports 6¹ sont disposés de manière à faire saillie de la partie centrale 4¹ du substrat 4 de manière essentiellement opposé l'un à l'autre. Chacun de ces supports 6¹ soutient une diode du type OLED 8. Une OLED est une diode à électroluminescence comprenant une superposition de plusieurs couches semiconductrices organiques entre deux électrodes dont l'une (au moins) est transparente. En l'occurrence, ces diodes OLED assurent une fonction de lanterne. La partie arrière 6² de la pièce rapportée 6 est configurée pour loger un connecteur 14 d'alimentation électrique.

Le substrat 4 du module 2 supporte également une ou plusieurs sources lumineuses (non visibles) entre les parois latérales 4² et les diodes OLED 8, cette ou ces sources lumineuses étant recouvertes d'un collimateur 12 en vue d'assurer une fonction de feux stop. Plus précisément, les rayons émis par ces sources lumineuses et déviés par le collimateur 12 pour rencontrer la face avant de la diode OLED 8 correspondante et y être réfléchis vers l'avant du module.

L'axe longitudinal du module représenté aux figures 1 et 2 correspond à son axe optique. Cela signifie que les différents faisceaux lumineux produits par le module 2 sont orientés essentiellement selon cet axe. Tous ces faisceaux sont préférentiellement dirigé vers l'avant du module (correspondant à la droite aux figures 1 et 2 et à l'arrière du véhicule).

Les collimateurs 10 et 12 sont des pièces en matière transparente ou translucide, telle que du verre ou du polycarbonate (PC) ou du polyméthacrylate de méthyle (PMMA). Ils comprennent des surfaces d'entrée et ou de sortie orientées de manière à dévier les rayons selon une direction principale, en application du principe de réfraction de Snell-Descartes. Les faces d'entrée et de sortie forment en effet chacune un dioptre, à savoir une surface séparant deux milieux transparents homogènes et isotropes, d'indices de réfraction différents. L'indice de réfraction de l'air est en effet de l'ordre de 1 alors que celui du verre et du polycarbonate est situé entre 1.4 et 1.6 environ. Le principe de fonctionnement d'un collimateur est bien connu en soi de l'homme de métier ; il n'est par conséquent pas nécessaire de le détailler davantage.

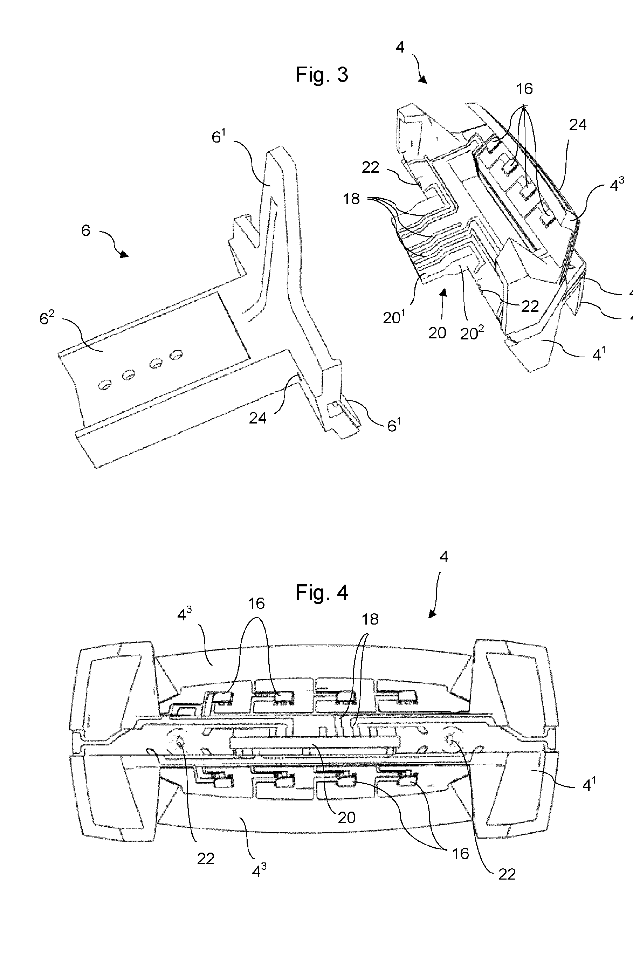

La figure 3 illustre de manière éclatée le support des sources lumineuses du module 2. Le support comprend le substrat 4 et la pièce rapportée 6. Le substrat 4 comprend une portion 20 faisant saillie de sa partie centrale 4¹. Cette portion 20 est destinée à coopérer par engagement avec le connecteur 14 (figures 1, 2, 5 et 6) en vue de l'alimentation électrique des sources lumineuses. Des pistes électriques 18 sont formées à la surface du substrat 4, de manière continue depuis les sources lumineuses jusqu'à la portion de connexion 20. La figure 3 illustre les sources lumineuses 16 du type LED disposées sur la face arrière de la paroi latérale 4² supérieure, étant entendu qu'un agencement similaire est prévu sur la paroi latérale inférieure, cet agencement n'étant pas visible à la figure 3. Des sources lumineuses (non visibles), également du type LED, sont également prévues entre les deux parois latérales 4², au fond de la cavité formée par lesdites parois. Ces sources lumineuses sont également reliées électriquement par les pistes électriques 18.

Les sources lumineuses, préférentiellement du type LED, disposées directement sur le substrat 4, sont ainsi alimentées électriquement par les pistes électriques s'étendant de manière continue depuis lesdites sources jusqu'à la portion de connexion 20.

Le substrat 4, y compris la portion de connexion 20, est en matière plastique réalisée par moulage et supporte les sources lumineuses et les pistes électriques, conformément à la technologie MID (acronyme de « Molded Interconnect Device »).

Le matériau plastique du substrat 4 peut être dopé en particules métalliques aptes à assurer l'accrochage des pistes électriques 18 en matériau métallique sur sa surface extérieure.

Les pistes électriques peuvent être réalisées par la technologie désignée par l'acronyme LDS signifiant en langue anglaise « Laser Direct Structuring ». Il s'agit de faire parcourir un rayon laser sur la surface correspondante du substrat, suivant la configuration des pistes à réaliser. Le rayon laser a pour effet de former une rugosité apte à favoriser l'accrochage. Cette étape est suivie d'une métallisation par trempage du substrat dans un ou plusieurs bains métalliques successifs.

Alternativement ou de manière complémentaire, les pistes électriques peuvent être réalisées par impression du type jet d'encre dont l'encre comprend des particules métalliques.

Les pistes peuvent également être réalisées par un moulage en deux étapes du substrat, ou encore désigné « Two shot molding » en langue anglaise. Il s'agit d'un processus de moulage par injection en utilisant deux résines différentes où une seule des deux résines est métallisable. Typiquement, la résine métallisable est de l'ABS et la résine non-métallisable est du polycarbonate. Le substrat est ensuite soumis à un processus de dépôt auto-catalytique où du butadiène est utilisé pour chimiquement rendre la surface rugueuse et permettre l'adhérence d'une couche primaire de cuivre.

En raison de la nature thermoplastique du substrat, l'utilisation de procédés de soudure classique pour les contacts électriques n'est pas adaptée. Les LED sont ainsi fixées mécaniquement et électriquement par application d'une colle à base polymère et chargée en éléments métalliques. Il s'agit ainsi d'un procédé d'application dite « à froid » ne mettant pas à mal le substrat. Après polymérisation de la colle, celle-ci assure la fixation mécanique et électrique de la LED.

La portion de connexion 20 du substrat 4 présente une forme de languette généralement rectangulaire. Elle peut présenter une variation d'épaisseur comme cela est visible à la figure 3. En effet, elle peut comprendre une zone distale 20¹ par rapport au substrat, cette zone distale 20¹ étant destinée à pénétrer dans le connecteur 14, et une zone proximale 20². La zone distale 20¹ peut ainsi présenter une épaisseur moyenne inférieure à celle de la zone proximale 20², en l'occurrence inférieure à 50% de l'épaisseur moyenne de ladite zone proximale. La transition entre ces deux zones 20¹ et 20² forme un ressaut. En l'occurrence, le ressaut est présent sur les deux faces principales de la portion de connexion 20. Les pistes électriques s'étendent essentiellement parallèlement les unes aux autres et selon l'axe principal de la portion de connexion 20. En l'occurrence l'axe principal de la portion de connexion correspond à l'axe optique et longitudinal du module. Les pistes électriques 18 s'étendent essentiellement jusqu'au bord distal de la portion de connexion, de manière à s'étendre sur la totalité de la zone distale 20¹.

Toujours en référence à la figure 3, la pièce rapportée 6 comprend deux orifices 24 (un seul est visible) destinés à recevoir les vis de fixation 15 (figure 2) au substrat. La pièce rapportée 6 comprend un orifice (non visible) destiné à recevoir la portion de connexion 20 lors de l'assemblage de la pièce 6 avec le substrat 4. La pièce rapportée 6 comprend sur sa portion arrière 6² également une cavité longitudinale destinée à permettre l'engagement du connecteur 14 (figures 1, 2, 5 et 6) avec la portion de connexion 20.

Encore en référence à la figure 3, on peut observer que les parois frontales 4³ du substrat 4 comprennent des pistes électriques 24 (également visibles à la figure 1), ces pistes étant directement reliées aux pistes d'alimentation des sources lumineuses qui sont destinées à être reliées à la masse. Ces pistes électriques 24 peuvent ainsi former un blindage électromagnétique, notamment pour les OLED 8 (voir figure 1) en formant avec elles un champ électromagnétique fermé.

La figure 4 est une vue de face arrière du substrat 4. On peut y observer la portion de connexion 20, plus particulièrement que des pistes électriques 18 s'étendent non seulement sur la face supérieure de ladite portion mais également sur sa face inférieure. On peut également observer les sources lumineuses 16 sur la face arrière de la paroi latérale supérieure ainsi que celles sur la face arrière de la paroi latérale inférieure. On peut aussi observer la présence de deux orifices 22, préférentiellement filetés, sur le bord arrière de la portion centrale 4¹ du substrat 4, ces orifices étant destinés à recevoir les vis 15 (figure 2) de fixation de la pièce 6 au substrat).

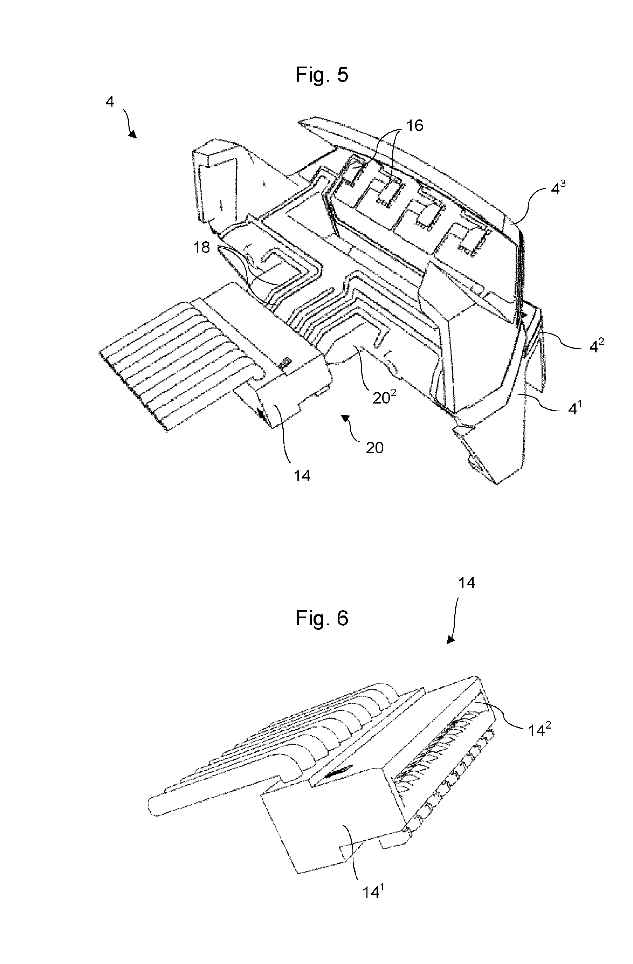

La figure 5 illustre le substrat 4 avec sa portion de connexion 20 en engagement avec le connecteur 14. On peut observer que seule la portion distale est en engagement avec le connecteur 14, la portion proximale 20² restant en dehors dudit connecteur.

La figure 6 illustre le connecteur 14 seul. Il comprend, essentiellement, un boîtier 14¹ formant une cavité 14² apte à recevoir la portion de connexion, en forme de languette, du substrat. Le boîtier 14¹ comprend dans sa cavité 14² une série de lamelles métalliques élastiques aptes à contacter les pistes électriques 18 sur la portion de connexion.

La portion de connexion 20 peut comprendre une encoche ou tout autre moyen servant de détrompeur par rapport au sens du connecteur. Ce dernier peut en effet en principe être orienté selon deux directions opposées à 180°, l'une correspondant à la bonne orientation et l'autre à une orientation à 180° de la bonne orientation. L'encoche peut être prévue sur un seul des deux côtés de la portion de connexion 20, ladite encoche autorisant à un bord correspondant du connecteur d'avancer jusqu'à ce que le connecteur soit en position d'engagement sur la portion de connexion. En cas d'orientation contraire, le bord en question va alors buter sur une partie de la portion de connexion dépourvue d'encoche, ne permettant pas l'engagement du connecteur.

## Revendications

1. Support de source(s) lumineuse(s) pour module lumineux (2), notamment pour véhicule automobile, comprenant :
- un substrat (4) avec au moins une zone de réception d'une source lumineuse (8, 16) ;
- des pistes électriques (18) déposées sur le substrat (4) jusqu'à la ou les zones de réception de source(s) lumineuse(s) (8, 16), lesdites pistes étant destinées à alimenter la ou les sources lumineuses ;
**caractérisé en ce que**
le substrat (4) comprend au moins une portion en saillie (20) venue de matière avec le reste du substrat et sur laquelle les pistes électriques (18) s'étendent depuis la ou les zones de réception, ladite ou lesdites portions (20) étant des portions de connexion aptes à coopérer avec un connecteur électrique (14), respectivement.

2. Support selon la revendication 1, **caractérisé en ce que** le substrat (4) est une pièce moulée rigide présentant une forme en trois dimensions.

3. Support selon l'une des revendications 1 et 2, **caractérisé en ce que** le substrat (4) est dans un matériau thermoplastique dopé en particules métalliques de manière à permettre l'accrochage des pistes électriques en matériau métallique.

4. Support selon l'une des revendications 1 à 3, **caractérisé en ce que** la ou au moins une des portions de connexion (20) a une forme de languette avec deux faces principales opposées, les pistes électriques (18) s'étendant préférentiellement sur lesdites deux faces.

5. Support selon la revendication 4, **caractérisé en ce que** la ou au moins une des portions de connexion (20) en forme de languette présente sur une zone distale (20¹) destinée à pénétrer le connecteur (14) une épaisseur réduite par rapport à l'épaisseur d'une zone proximale (20²) de ladite portion (20), l'épaisseur de la zone distale (20¹) étant préférentiellement inférieure à 50% de l'épaisseur de la zone proximale (20²).

6. Support selon l'une des revendications 1 à 5, **caractérisé en ce que** la ou au moins une des portions de connexion (20) comprend une encoche servant de détrompeur avec le connecteur (14).

7. Support selon l'une des revendications 1 à 6, **caractérisé en ce qu'**il comprend la ou les sources lumineuses (8, 16), ladite ou lesdites sources (16) étant du type diode à électroluminescence et reliées aux pistes électriques (18) par une colle chargée de particules métalliques, ladite colle étant préférentiellement une colle polymère apte à polymériser après application.

8. Support selon l'une des revendications 1 à 7, **caractérisé en ce que** le substrat (4) comprend une portion centrale (4¹) et une cavité avec un fond etau moins une paroi latérale (4²), la ou au moins une des zones de réception de source(s) lumineuse(s) (16) étant sur le fond de la cavité, la ou les portions de connexion (20) étant en saillie depuis la portion centrale (4¹) dans une direction opposée à la cavité.

9. Support selon la revendication 8, **caractérisé en ce que** le substrat (4) comprend au moins une paroi frontale (4³) faisant saillie de la ou d'au moins une des parois latérales (4²), au moins une des pistes électriques (18) s'étendant sur ladite ou au moins une desdites parois frontales (4³) et étant destinée à être reliée à la masse en vue de former un blindage électromagnétique (24).

10. Support selon l'une des revendications 1 à 9, **caractérisé en ce qu'**il comprend, en outre :
- une pièce (6) rapportée sur le substrat (4), ladite pièce (6) comprenant une ouverture destinée à recevoir la ou au moins une des portions de connexion (20) du substrat (4).

11. Support selon la revendication 10, **caractérisé en ce que** la pièce rapportée (6) comprend au moins une portion en saillie (6¹) supportant une source lumineuse (8) du type diode à électroluminescence organique.

12. Module lumineux (2), notamment pour véhicule automobile, comprenant :
- un support de source(s) lumineuse(s) ;
- au moins un dispositif optique (10, 12) apte à dévier des rayons lumineux produit par la ou les sources lumineuses en vue de former au moins un faisceau lumineux ;
**caractérisé en ce que**
le support (4, 6) est conforme à l'une des revendications 1 à 11.

13. Module lumineux (2) selon la revendication 12, **caractérisé en ce que** le ou les dispositifs optiques (10, 12) sont supportés directement par le substrat (4).

14. Module lumineux (2) selon l'une des revendications 12 et 13, **caractérisé en ce que** le ou au moins un des dispositifs optiques (10, 12) comprend un élément translucide ou transparent formant au moins un, préférentiellement deux dioptres, ledit élément étant un collimateur de rayons optiques en vue de former le ou un des faisceaux lumineux.

15. Module lumineux (2) selon la revendication 14, **caractérisé en ce que** le support (4, 6) est conforme à l'une des revendications 8 et 9, et **en ce que** le ou un des collimateurs (10) est logé dans la cavité du support.
